Europäisches Patentamt

European Patent Office

Office européen des brevets

(11) Publication number : **0 325 097 B1**

## (12) EUROPEAN PATENT SPECIFICATION

(45) Date of publication of patent specification :
**15.04.92 Bulletin 92/16**

(51) Int. Cl.$^5$ : **C23F 3/03**

(21) Application number : **88850420.6**

(22) Date of filing : **12.12.88**

(54) **Chemical polishing bath and method for aluminum alloys.**

(30) Priority : **15.01.88 US 145806**

(43) Date of publication of application :
**26.07.89 Bulletin 89/30**

(45) Publication of the grant of the patent :
**15.04.92 Bulletin 92/16**

(84) Designated Contracting States :
**DE FR GB**

(56) References cited :
**DE-B- 1 073 827**
**US-A- 2 705 191**
**US-A- 2 729 551**

(56) References cited :
**ELECTROPLATING AND METAL FINISHING,
vol. 8, no. 1, January 1955, pages 4-8; R.
PINNER: "Motor Industry finds an alternative
to chromium plate in chemical polished alumi-
nium"**
**K.R. VAN HORN: "Aluminum", vol. 3, 3rd edi-
tion, 1967, page 595, American Society for
Metals, Metals Park, Ohio, US: "Fabrication
and fishing"**

(73) Proprietor : **International Business Machines
Corporation
Old Orchard Road
Armonk, N.Y. 10504 (US)**

(72) Inventor : **Mahmoud, Issa Said
10500 Settler's Trail
Austin, TX 78750 (US)**

(74) Representative : **Johansson, Lars E. et al
IBM Svenska AB Intellectual Property
Department 4-01
S-163 92 Stockholm (SE)**

EP 0 325 097 B1

Jouve, 18, rue Saint-Denis, 75001 PARIS

## Description

The present invention relates to chemical polishing of aluminium alloys in general and in particular to a polishing bath composition including phosphoric acid, nitric acid, sodium nitrate and water. Further, it relates to a process for performing polishing by using said polishing bath composition.

Both patent literature and general scientific literature contain many references related to polishing aluminum. The Metal Finishing Handbook (Metals and Plastic Publishing Company) and Wernick and Pinner Surface Treatment of Aluminum, 4th Ed., 1974, pp. 120-146, discuss polishing at length. Prior art polishing methods cause the formation of smut on the surface of the workpiece which necessitates the use of additional process steps, either mechanical or chemical, to remove. These additional steps increase the total number of manufacturing steps and result in overall higher cost.

A bath formula is presented which produces mirror finishes on both wrought, heat-treatable and non-heat treatable aluminum alloys. Cleaned and rinsed aluminum workpieces are chemically polished in a bath comprising phosphoric acid, nitric acid, sodium nitrate and water for 1 to 2 minutes at a temperature in the range of from 80 to 90°C. After polishing, the workpieces are rinsed in warm deionized water for 1 to 2 minutes. The result is an aluminum workpiece suitable for immediate use as in decorative applications or ready for another step, such as anodizing as part of a manufacturing process for printed circuit boards. This polishing bath produces microetched surfaces which increase nucleation sites, an important consideration for even anodic coatings.

A bath in which aluminum alloy workpieces may be immersed for chemical polishing comprises 784 milliliters of phosphoric acid, 98 milliliters nitric acid, 40 grams sodium nitrate and 118 milliliters water.

The total immersion period is preferably 1 to 2 minutes at a temperature of 80 to 90°C. Prior to immersion, the aluminum alloy workpieces must be cleaned, preferably either in an organic solution of the halogenated type or in a mild alkaline solution. The workpiece is then rinsed in water at room temperature. Upon removal from the polishing bath, the workpieces are rinsed in warm deionized water at a temperature of 120 to 130°F (48,9 - 54,4°C) for 1 to 2 minutes.

While the above parameters yield optimum results, satisfactory results may be obtained with some latitude allowed in the amount of the bath constituents as long as the amount used is somewhere between 75% and 125% of the preferred value.

It is believed that this formulation is based on the oxidizing power theory whereby at this concentration level, the oxidizing power of the solution is sufficient to remove heat scale, oxides and other contaminants.

Sodium nitrate provides continual replenishment of nitric acid in the solution, thus maintaining a longer useful life of the polishing bath. Nitric acid is present in low enough concentration to avoid severe etching of the workpieces.

While the particular bath formulation is the result of an effort to perfect pre-treatment for aluminum workpieces prior to anodization, it has been found that the chemical polishing bath of the invention is also effective for producing a final finish on aluminum alloys for use in decorative applications.

A further advantage is that the chemical polishing bath of the invention is also useful for removing burrs present at the surface following stamping, drilling and other cutting steps. The disclosed chemical polishing formula results in aluminum having a very smooth surface, making it suitable for the manufacture of other devices requiring great precision, such as magnetic storage media surfaces.

When chemical polishing is conducted in accordance with the invention prior to plating aluminum, satisfactory results are also obtained. Conventional commercial plating methods often require aluminum alloys to be treated with a phosphate or zincate coating to protect the surface against unwanted oxidation. These coatings are then removed in an atom by atom displacement process during plating. In such processes, bath contamination is always a danger and there is a high cost associated therewith. The present chemical polishing process yields aluminum alloy workpieces having on the surface thereof an extremely thin oxide layer in the range of 10 to 50 Angstroms, which has been found to have no adverse effects on subsequent plating adhesion. In fact, aluminum alloy polished in accordance with the invention have been successfully plated after 6 to 8 months of storage.

The following examples are illustrative of the practice of the present invention.

Example 1.

Samples of wrought aluminum alloy 6061-T6 were degreased in a 1,1,1 trichloroethylene and then treated in a preheated solution having the composition of 784 ml phosphoric acid, 98 ml nitric acid, 40 grams sodium nitrate and 118 ml water, all per liter of solution. The solution temperature was 85°C and the treatment time lasted for 3 minutes. The samples were rinsed in warm deionized water for 1 minute. No smut was formed on the surface of the samples and a mirrorlike appearance was obtained.

Example 2.

Samples of heat treatable and non-heat treatable aluminum alloys, 1110, 2024, 3000, 5052 and 6063 were treated as in Example 1. No surface smut was found on any of the samples; and again, a mirrorlike finish was obtained.

Example 3.

Other trials with various aluminum alloys including 7075 and 8086 were carried out as in Example 1 above, with the exception that the temperature of the solution was raised to 90°C. Similar smut free mirrorlike finish results were obtained.

Example 4.

Concentrations of nitric acid and sodium nitrate were reduced to 75% of their previous values in the polishing bath in Example 1; 75 milliliters nitric acid, 30 grams sodium nitrate. Temperature and treatment period were as in Example 1. Similar smut free mirrorlike finish results were obtained.

Example 5.

Another trial was conducted as in Example 1, with the exception that treatment time was decreased to 2 minutes from 3. Identical results were obtained.

While the invention has been described having reference to a preferred bath composition formulation along with variations in process parameters, those skilled in the art will appreciate that these and other minor changes in composition concentrations and process parameters may be made without departing from the scope of the invention.

**Claims**

1. Polishing bath formula for polishing aluminium alloys comprising:

phosphoric acid, nitric acid, sodium nitrate and water. characterized in that the constituents are present in the following amounts:

588 - 940 ml, preferably from 705 to 862 milliliters, most preferably 784 ml, phosphoric acid

73 - 118 ml, preferably from 90 to 110 milliliters, most preferably 98 ml, nitric acid

30 - 48 g, preferably from 35 to 45 grams, most preferably 40 g, sodium nitrate, and

88 - 142 ml, preferably from 100 to 130 milliliters, most preferably 118 ml, water.

2. A method of polishing aluminum alloys comprising the steps of:

immersing clean aluminum alloy workpieces in a polishing bath as defined in claim 1, for a period of 48 s to 192 s at temperature in the range of 80 to 90°C; and

rinsing the workpieces in deionized water.

3. The method as claimed in claim 2 wherein the rinsing step includes:

maintaining deionized water at a temperature in the range of from 115 to 135°F (46,1 - 57,2°C).

4. The method of claim 2, wherein rinsing of the workpieces in deionized water is carried out at a temperature in the range of from 110 to 130°F (43,3 - 54,4°C).

5. The method as claimed in claim 4 including a cleaning step comprising:

immersing the workpieces in a halogenated organic solution.

6. The method as claimed in claim 4 including a cleaning step comprising:

immersing the workpieces in a mild alkaline solution.

7. The method as claimed in claim 4 including a first rinsing step after the cleaning step, comprising

rinsing the workpieces in flowing room temperature water.

8. The method as claimed in claim 2 wherein the immersing step further includes:

maintaining the temperature of the solution at substantially 80°C.

9. The method as claimed in claim 8 wherein the immersing step further includes:

keeping the workpieces in the solution for 1 to 2 minutes.

**Patentansprüche**

1. Polierbadzusammensetzung zum Polieren von Aluminiumlegierungen, enthaltend:

Phosphorsäure, Salpetersäure, Natriumnitrat und Wasser,

dadurch gekennzeichnet, daß die Bestandteile in folgenden Mengen vorhanden sind:

588 - 940 ml, vorzugsweise 705 bis 862 Milliliter, besonders bevorzugt 784 ml Phosphorsäure,

73 - 118 ml, vorzugsweise 90 bis 110 ml, besonders bevorzugt 98 ml Salpetersäure,

30 bis 48 g, vorzugsweise 35 bis 45 Gramm, besonders bevorzugt 40 g Natriumnitrat, und

88 - 142 ml, vorzugsweise 100 bis 130 Milliliter, besonders bevorzugt 118 ml Wasser.

2. Verfahren zum Polieren von Aluminiumlegierungen, die folgenden Schritte enthaltend:

gereinigte Werkstücke aus einer Aluminiumlegierung werden für eine Zeitdauer von 48 s bis 192 s bei einer Temperatur im Bereich von 80°C bis 90°C in ein Polierbad nach Anspruch 1 getaucht und

die Werkstücke werden in vollentsalztem Wasser gespült.

Verfahren nach Anspruch 2, bei welchem der Spülschritt beinhaltet:

vollentsalztes Wasser wird bei einer Temperatur im Bereich von 115 bei 135°F (46,1 - 57,2°C) gehalten.

4. Verfahren nach Anspruch 2, bei welchem das Spülen der Werkstücke in vollentsaltzem Wasser bei einer Temperatur im Bereich von 110 bis 130°F (43,3 - 54,5°C) durchgeführt wird.

5. Verfahren nach Anspruch 4, bei welchem ein Reinigungsschritt beinhaltet:

die Werkstücke werden in eine halogenhaltige organische Lösung getaucht.

6. Verfahren nach Anspruch 4, bei welchem ein Reinigungsschritt beinhaltet:

die Werkstücke werden in eine milde alkalische Lösung getaucht.

7. Verfahren nach Anspruch 4, das einen ersten Spülschritt nach dem Reinigungsschritt enthält, wobei

die Werkstücke in fließendem Wasser mit Raumtemperatur gespült werden.

8. Verfahren nach Anspruch 2, bei welchem der Schritt des Eintauchens weiters beinhaltet:

die Temperatur der Lösung wird im wesentlichen bei 80°C gehalten.

9. Verfahren nach Anspruch 8, bei welchem der Schritt des Eintauchens weiters beinhaltet:

die Werkstücke werden für 1 bis 2 Minuten in der Lösung gelassen.

## Revendications

1. Formule de bain de polissage pour le polissage d'alliages d'aluminium, comprenant:

de l'acide phosphorique, de l'acide nitrique, du nitrate de sodium et de l'eau, caractérisée en ce que les constituants sont présents dans les quantités suivantes:

588 à 940 ml, de préférence de 705 à 862 ml et le plus avantageusement, 784 ml d'acide phosphorique;

73 à 118 ml, de préférence de 90 à 110 ml et le plus avantageusement, 98 ml d'acide nitrique;

30 à 48 ml, de préférence de 35 à 45 ml et le plus avantageusement, 40 ml de nitrate de sodium, et

88 à 142 ml, de préférence de 100 à 130 ml et le plus avantageusement, 118ml d'eau.

2. Procédé de polissage d'alliages d'aluminium comprenant les étapes suivantes:

immersion des pièces d'ouvrage d'alliage d'aluminium propres dans un bain de polissage suivant la revendication 1, pendant une période de 48 à 192 secondes à une température de l'ordre de 80 à 90°C; et

rinçage des pièces d'ouvrage dans de l'eau désionisée.

3. Procédé suivant la revendication 2 dans lequel l'étape de rinçage comprend:

le maintien de l'eau désionisée à une température de l'ordre de 46,1 à 57,2°C (115 à 135°F).

4. Procédé suivant la revendication 2 dans lequel le rinçaqe des pièces d'ouvrage dans de l'eau désionisée est effectuée à une température de l'ordre de 43,3 à 54,4°C (110 à 130°F).

5. Procédé suivant la revendication 4 incluant une étape de nettoyage comprenant:

l'immersion des pièces d'ouvrage dans une solution organique halogénée.

6. Procédé suivant la revendication 4 incluant une étape de rinçage comprenant:

l'immersion des pièces d'ouvrage dans une solution alcaline faible.

7. Procédé suivant (a revendication 4 incluant une première étape de rinçage après l'étape de nettoyage, comprenant

le rinçage des pièces d'ouvrage dans de l'eau courante à température ambiante.

8. Procédé suivant la revendication 2 dans lequel l'étape d'immersion comprend de plus:

le maintien de la température de la solution à pratiquement 80°C.

9. Procédé suivant la revendication 8 dans lequel l'étape d'immersion comprend de plus:

le maintien des pièces d'ouvrage dans la solution pendant 1 à 2 minutes.